# EUROPÄISCHE PATENTSCHRIFT

(11) **EP 1 858 065 B1**
(45) Veröffentlichungstag und Bekanntmachung des Hinweises auf die Patenterteilung: **16.02.2011**
(21) Anmeldenummer: 07009106.1
(22) Anmeldetag: 05.05.2007
(51) Int. Cl.: H01L 21/335, H01L 21/28

(54) **Verfahren zur Herstellung eines Halbleiterbauelements mit einer in einer Doppelgrabenstruktur angeordneten metallischen Gateelektrode**
Method for manufacturing a semiconductor element with a metal gate electrode in a double trench structure
Procédé de fabrication d'un élément semi-conducteur doté d'une électrode porte métallique agencée dans une double structure à tranchée

(30) Priorität: 15.05.2006 DE 102006022508
(43) Veröffentlichungstag der Anmeldung: 21.11.2007
(73) Patentinhaber: United Monolithic Semiconductors GmbH, 89081 Ulm (DE)
(72) Erfinder: Behammer, Dag, 89079 Ulm (DE)
(74) Vertreter: Weber, Gerhard

(56) Entgegenhaltungen:
- US-A- 6 087 256
- US-A1- 2004 082 158
- US-B1- 6 180 968

## Beschreibung

Die Erfindung betrifft ein Verfahren zur Herstellung eines Halbleiterbauelements, insbesondere eines pHEMT-Feldeffekttransistors, mit einer in einer Doppelgrabenstruktur angeordneten metallischen Gateelektrode.

Halbleiterbauelemente mit in einer auch als double recess bezeichneten Doppelgrabenstruktur angeordneter Gateelektrode sind in verschiedener Ausführung bekannt.

In US 5 796 132 werden die beiden Recessgräben einander durch Justage zugeordnet und bei der Ätzung durch eine Lack- oder SiN-Hard-Maske maskiert. Außerdem ist die Isolation im Falle eines pHEMTs nur durch eine Überätzung auf einer Stopschicht möglich. Dadurch entstehen Hohlräume, die später nicht mehr passiviert werden können. Der T-förmige Gatekopf wird in dem gezeigten Verfahren durch die Ätzung einer ganzflächig abgeschiedenen Metallisierung gebildet. In US 5 556 797 werden die beiden Recessgräben zwar selbstjustiert zueinander gebildet, jedoch ist es nicht möglich, einen niederohmigen T-förmigen Gatekopf zu bilden, der jedoch für Hochfrequenzanwendungen notwendig ist. Gleiches gilt auch für US 5 641 977.

Die US 2004/0082158 A1 beschreibt ein Verfahren, bei welchem auf der Halbleiterschichtenfolge mehrere Photolackschichten abgeschieden werden, in welchen für eine spätere Herstellung einer T-förmigen Gateelektrode im Lift-off-Verfahren Strukturen für den Gatekopf vorbereitet werden. In der untersten, auf der hochdotierten Kontaktschicht der Halbleiterschichtenfolge abgeschiedenen Lackschicht wird eine die Struktur des Gatefußes bestimmende Öffnung erzeugt. Die Lackschichten bleiben in den folgenden Verfahrensschritten bis zum Aufdampfen des Gatemetalls erhalten. Unter der untersten Lackschicht wird durch Unterätzung in der Kontaktschicht eine Grabenstruktur bis zu einer Barriereschicht erzeugt und Gatemetall durch die Öffnung der untersten Lackschicht zur Bildung des Gatefußes auf der Barriereschicht und gleichzeitig in die Strukturen der oberen Lackschichten zur Bildung des Gatekopfes abgeschieden. Durch Auflösen der Lackschichten wird die Gateelektrode freigelegt. Danach werden noch ohmsche Kontakte auf der hochdotierten Kontaktschicht erzeugt.

In der US 6 180 968 B1 ist ein Heterojunction-Feldeffekttransistor beschrieben, bei welchem in oberhalb einer Kanalschicht abgeschiedenen Halbleiterschichten eine Doppelgrabenstruktur erzeugt wird. Über den Halbleiterschichten wird eine erste Maskierungsschicht und auf dieser eine Photolackschicht als zweite Maskierungsschicht abgeschieden. Eine in der Photolackschicht erzeugte Öffnung dient als Maske zur Erzeugung einer durch Unterätzung breiteren zweiten Öffnung in der zweiten Maskierungsschicht. Diese zweite Öffnung dient als Maske für eine anisotrope Ätzung der eine Kontaktschicht bildenden obersten Halbleiterschicht bis zu einer Stop-Schicht, wobei sich die Öffnung in der Kontaktschicht nach unten verjüngt. Nach Entfernen der Stop-Schicht unter der in der Kontaktschicht erzeugten Öffnung wird diese als Maske für eine erneute anisotrope Ätzung der darunter liegenden Halbleiterschicht benutzt, wobei in dieser wiederum eine sich nach unten verjüngende dritte Öffnung bis zu einer weiteren Stop-Schicht erzeugt wird. Nach Entfernen der weiteren Stop-Schicht unter der Öffnung wird durch die bis dahin beibehaltene Öffnung in der Photolackschicht im Lift-Off-Verfahren Gatemetall abgeschieden, welches die dritte Öffnung als Gatefuß vollständig ausfüllt und als Gatekopf von dem Halbleitermetall der Kontaktschicht beabstandet ist.

Der Erfindung liegt die Aufgabe zugrunde, ein vorteilhaftes Verfahren zur Herstellung eines Halbleiterbauelements mit einer metallischen Gateelektrode und einer Doppelgrabenstruktur anzugeben.

Die Erfindung ist im Patentanspruch 1 beschrieben. Die abhängigen Ansprüche enthalten vorteilhafte Ausgestaltungen und Weiterbildungen der Erfindung.

Die Erzeugung der Doppelgrabenstruktur erfolgt durch das erfindungsgemäße Verfahren vorteilhafterweise in selbstjustierender Positionierung des breiten und des schmalen Grabens in mehreren Schritten, wobei in Zwischenschritten erzeugte Strukturen vorteilhafterweise als Maskierung für nachfolgende Ätzschritte dienen können. Auch für den Gatefuß ergibt sich eine selbstzentrierende Position innerhalb des schmalen Grabens.

Insbesondere kann mit der ersten Öffnung in der ersten Hilfsschicht als Hardmaske sowohl die Position des breiten Grabens durch Unterätzung der ersten Hilfsschicht als auch die Position des schmalen Grabens durch Übertragung der Struktur der ersten Öffnung in eine weitere Öffnung einer weiteren Hilfsschicht und deren Unterätzung festgelegt werden und damit eine zuverlässige selbstjustierende gegenseitige laterale Ausrichtung des breiten und des schmalen Grabens erreicht werden.

Wesentlich ist insbesondere, dass eine weitere Hilfsschicht durch die erste Öffnung in den zweiten Graben und dort insbesondere auf die Abschirmschicht abgeschieden wird und die in dieser weiteren Hilfsschicht erzeugte weitere Öffnung als Hardmaske für die Ätzung des schmalen Grabens dient. Vorzugsweise wird der breite Graben nach Abscheiden der weiteren Hilfsschicht mit einem verfestigbaren flüssigen Füllmaterial, vorzugsweise einem polymerisierbaren Material ausgefüllt und das Material insbesondere zu einem Polymer verfestigt. Die Übertragung der Struktur der ersten Öffnung erfolgt dann vorteilhafterweise in eine zweite Öffnung in dem Polymer und der zwischen dem Polymer und der Abschirmschicht liegenden weiteren Hilfsschicht. In vorteilhafter Weiterbildung wird vor der Abscheidung des Gatemetalls die erste Hilfsschicht über dem Polymer oder vorzugsweise insgesamt entfernt und Gatemetall für den Gatekopf auf dem Polymer abgeschieden.

Die Erzeugung von Strukturen einschließlich der Herstellung von Öffnungen in Schichten und der Freilegung von Gräben oder Strukturen erfolgt in gebräuchlicher Weise durch in vielfacher Zusammensetzung und Anwendung bekannte Ätzmittel, welche insbesondere auch materialselektiv ausgewählt und eingesetzt werden können.

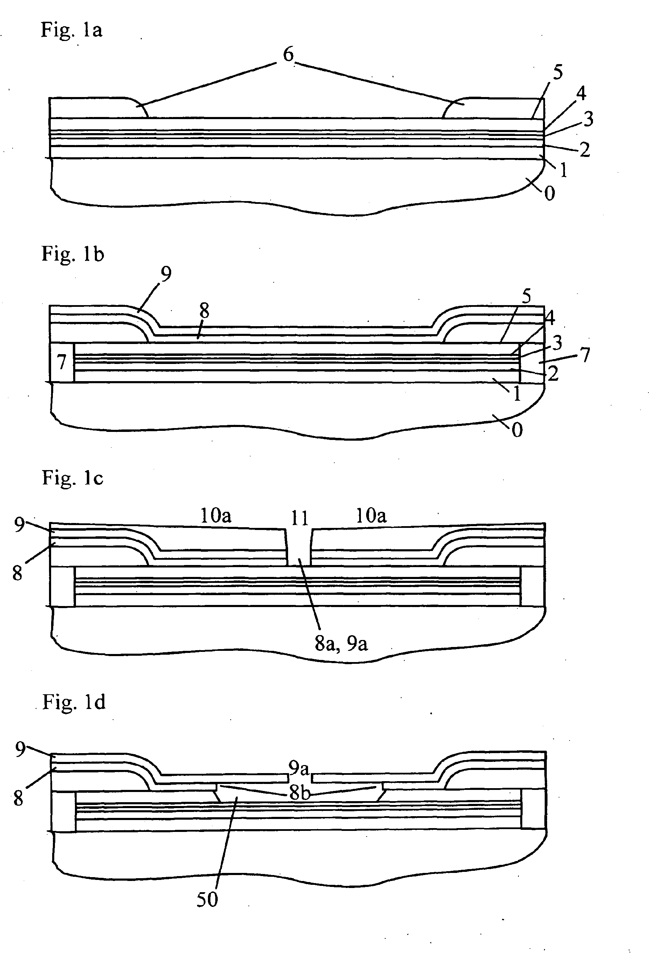

Die Erfindung ist nachfolgend anhand eines bevorzugten Ausführungsbeispiels unter Bezugnahme auf die Abbildungen Fig. 1a bis Fig. 1i in aufeinander folgenden Verfahrensstadien noch eingehend veranschaulicht.

Das erfindungsgemäße Verfahren beinhaltet eine in hohem Maße skalierbare und selbstjustierte Integration zur Definition des Gatebereiches mit Gatefuß und Gatekopf. Der Gatefuß kann dabei Abmessungen von z. B. 70 - 600 nm besitzen, während der Gatekopf typischerweise nach beiden Seiten um 50 - 300 nm breiter sein kann. Der Gatefuß ist in einem schmalen Graben in der Abschirmschicht zentriert, welcher wiederum zu dem breiten Graben in der hochdotierten Kontaktschicht zentriert ist. Der breite Graben ist dabei typischerweise beidseitig 200 mm - 1000 mm breiter als der schmale Graben.

Ausgehend von dem GaAs Substrat 0, definieren die Schichten 1-5 in Fig. 1a das Vertikalprofil eines Feldeffekt-Transistors, insbesondere eines pHEMT Hochfrequenz-Leistungsfeldeffekttransistors, das in seiner Dicken- und Elementstruktur in Abhängigkeit von der Anwendung variieren kann. Die Schichtendickenverhältnisse sind nicht maßstäblich zu nehmen. Grundsätzlich stellt 1 den Buffer dar, 2 bildet die Kanalschicht für das zweidimensionale Elektronengas, 3 ist eine Barrierenschicht vorzugsweise mit oben liegender Stopschicht, 4 ist eine niedrigdotierte Abschirmschicht, die ebenfalls vorzugsweise nach oben mit einer Stopschicht abschließt, und die Schicht 5 als oberste Halbleiterschicht bildet eine hochdotierte Kontaktschicht zur niederohmigen Bauelementkontaktierung. Die Schichten 4 und 5 bestehen vorzugsweise aus GaAs und die Stopschichten vorteilhafterweise aus AIAs oder InGaP.

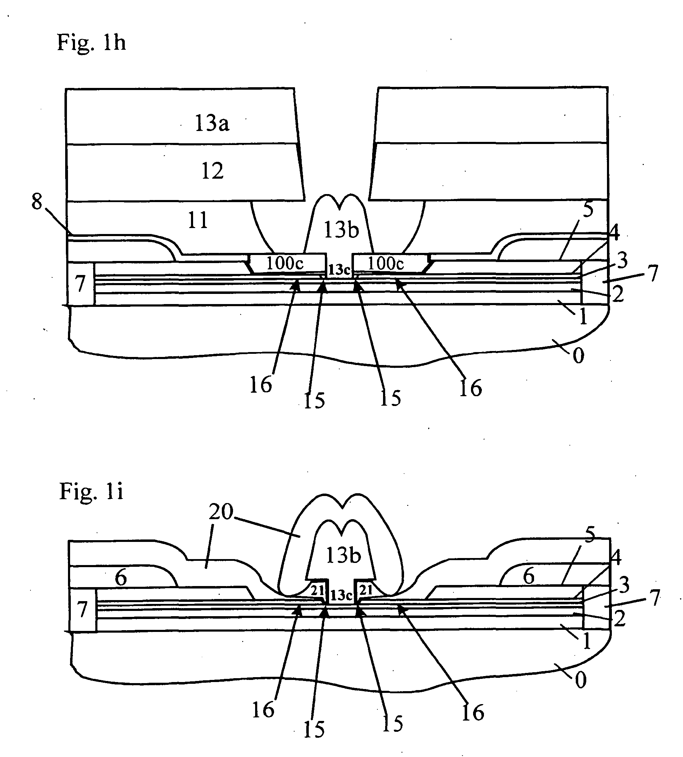

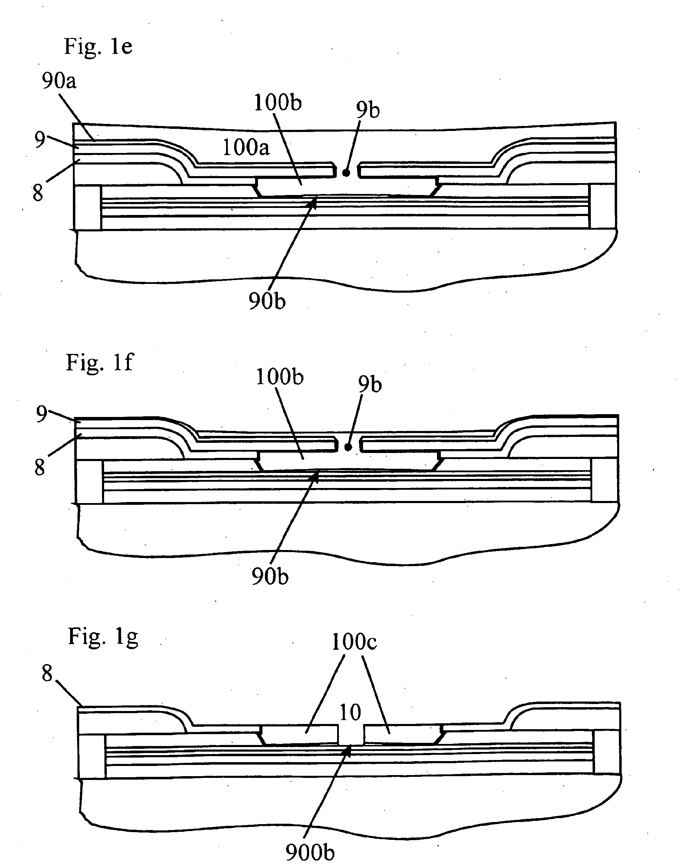

Nach Definition ohmscher Kontakte 6 auf der Kontaktschicht 5 gemäss Fig. 1 a erfolgt, vorzugsweise durch PECVD, die Abscheidung einer dielektrischen Zwischenschicht 8, vorzugsweise einer SiO₂-Schicht und einer dielektrischen Hilfsschicht 9, vorzugsweise einer Siliziumnitrid(SiN)-Schicht. Die laterale Isolation der Transistoren erfolgt durch eine fotolackmaskierte Implantation zur Bildung isolierter Feldgebiete 7 (Fig. 1b).

In einem nächsten Lithografieprozessschritt wird eine Photolackschicht aufgebracht und eine Lithografiemaske mit einer Struktur für den Gatefuß relativ zu den ohmschen Kontakten justiert. Nach Belichtung und Entwicklung des Photolacks entsteht die Öffnung 11 im Photolack 10a, welche z. B. durch trockenchemisches Plasmaätzen in die darunter liegende Doppelschicht von erster Hilfsschicht 9 und Zwischenschicht 8 übertragen wird, so dass in diesen Schichten Öffnungen 9a bzw. 8a entstehen (Fig. 1c). Der Photolack 10a wird danach wieder entfernt.

In einer nachfolgenden nasschemischen Ätzung der Zwischenschicht selektiv zu der ersten Hilfsschicht 9 und der Kontaktschicht 5 wird die Öffnung 8a in der Zwischenschicht 8 auf eine größere Öffnung 8b erweitert, deren laterale Weite über die Parameter des Ätzvorgangs, insbesondere dessen Dauer, gut einstellbar ist. Die Öffnung 8b in der Zwischenschicht dient in einem nachfolgenden Ätzschritt als Hardmaske zur Ätzung des breiten Grabens 50 in der Kontaktschicht 5, wobei die Ätzstopschicht zwischen Abschirmschicht und Kontaktschicht die Ätzung vertikal begrenzt, und die Struktur nach Fig. 1d entsteht.

Danach wird eine weitere Hilfsschicht, vorzugsweise SiN abgeschieden, wobei die Abscheidung als gleichmäßige Schicht 90a auf der ersten Hilfsschicht und durch die Öffnung 9a in der ersten Hilfsschicht auch als Hardmaskenschicht 90b in den durch die Öffnung 8b und den breiten Graben 50 gebildeten Hohlraum unter der ersten Hilfsschicht, und dort insbesondere über der Abschirmschicht 4 und an den Flanken der Öffnung in der ersten Hilfsschicht nun mit 9b bezeichnet, erfolgt. Durch Einstellung der Parameter der Abscheidung der weiteren Hilfsschicht, welche vorzugsweise mittels eines PECVD-Verfahrens abgeschieden wird, wird die weitere Hilfsschicht 90b auf der Abschirmschicht 4 mit gegenüber der Öffnung 9a größerer Breite oder auch auf der gesamten Innenfläche des Hohlraums abgeschieden, wobei die Schichtdicke der weiteren Hilfsschicht 90b auf der Abschirmschicht geringer ist als die Schichtdicke der weiteren Hilfsschicht 90a auf der ersten Hilfsschicht.

l7orteilhafterweise wird dann ein Polymer, insbesondere BCB aufgebracht, welches neben einer Schicht auf 100a auf der ersten Hilfsschicht 9 auch mit einem Anteil 100b die Öffnung 9b und den unter der ersten Hilfsschicht durch die Öffnung 8b und den breiten Graben 50 gebildeten Hohlraum ausfüllt (Fig. 1e).

Durch eine nachfolgende ganzflächige Plasmarückätzung wird die Polymerschicht weitgehend und teilweise auch die weitere Hilfsschicht 100a abgetragen (Fig. 1f), danach die Struktur der Öffnung 9b in der ersten Hilfsschicht als Öffnung 10 in die Polymerschicht 100b und als Öffnung 900b in die weitere Hilfsschicht 90b übertragen. Die erste Hilfsschicht wird vorteilhafterweise vollständig abgetragen und das den Hohlraum ausfüllende Polymer als seitliche Begrenzungen 100c der Öffnung 10 freigelegt, so dass die in Fig. 1g skizzierte Struktur entsteht. Während des Ätzvorgangs können die Eigenschaften der verschiedenen Materialien der Zwischenschicht 8, der ersten Hilfsschicht 9, der zweiten Hilfsschicht 90a, 90b und des Polymers 100a, 100b zur selektiven Ätzung durch geeignete Einstellungen der Ätzparameter ausgenutzt werden.

In der in Fig. 1g skizzierten Struktur bilden die durch das Polymer 100c seitlich begrenzte Öffnung 10 und die Öffnung 900b als Hardmaske in der weiteren Hilfsschicht 90b die laterale Begrenzung für eine nachfolgende Ätzung des schmalen Grabens durch Ätzen der Abschirmschicht 4 in der Öffnung 900b und seitlich davon unter der weiteren Hilfsschicht 90b.

Vor Ätzung des schmalen Grabens wird für die Herstellung des Gatekopfes in Lift-off-Technik in einem photolithographischen Prozess eine Maskenstruktur für den Gatekopf erzeugt. Hierfür werden zwei Photolackschichten 11 und 12 auf der in Fig. 1g skizzierten Anordnung abgeschieden, wobei vorzugsweise eine untere Lackschicht aus PGMI und eine obere Lackschicht 12 aus einem dünnen positiven Lack besteht. Nach Ausrichtung einer Photomaske, Belichtung und Entwicklung der Lackschichten entsteht eine die Breite des Gatekopfes bestimmende Öffnung in der oberen Lackschicht 12 und eine lateral größere Öffnung in der unteren Lackschicht 11.

Vor dem Abscheiden des Gatemetalls wird mit den Öffnungen 10 in dem Polymer 100c und 900b in der weiteren Hilfsschicht 90b ein schmaler Graben 15 in der Abschirmschicht 4 bis zu der Barriereschicht 3 erzeugt, welcher durch definierte laterale Unterätzung der weiteren Hilfsschicht 90b um ein geringes Maß breiter ist als die Öffnung 90b. Seitlich des schmalen Grabens ist die Barriereschicht durch die Abschnitte 16 der Abschirmschicht abgedeckt.

Nach Ätzung des schmalen Grabens 15 wird Gatemetall aufgedampft, welches in dem schmalen Graben und den Öffnungen 900b und 10 den Gatefuß und über dem Polymer 100c den Gatekopf 13b einer T-förmigen Gateelektrode bildet. Die obere Fläche der Polymerschichten 100c kann dadurch auf vorteilhafte Weise zur definierten Einstellung der Unterkante der überhängenden seitlichen Bereich des Gatekopfs dienen. Die obere Fläche der Polymerschichten 100c fällt im wesentlichen mit der oberen Fläche der Zwischenschicht 8 zwischen den ohmschen Kontakten 6 zusammen und kann daher bereits beim Abscheiden der Zwischenschicht 8 vorgegeben werden.

Nach Entfernen der Metallschicht 13a auf der Photolackschicht 12 durch Lift-off werden das Polymer 100c, die weitere Hilfsschicht 90b und die Zwischenschicht 8 entfernt, wofür vorteilhafterweise ein CF₄-basiertes Plasma eingesetzt werden kann.

Eine Passivierungsschicht 20, vorzugsweise SiN, wird ganzflächig, insbesondere auch in die Gräben 50, 15 unterhalb der überhängenden seitlichen Gatekopfbereiche, wobei die Passivierungsschicht unter den überhängenden Gatekopfbereichen Hohlräume 21 einschließt (Fig. 1 i). Durch die Hohlräume 21 können Rückkoppelkapazitäten auf besonders vorteilhafte Weise reduziert werden.

## Patentansprüche

1. Verfahren zur Herstellung eines mikroelektronischen Bauelements einer T-förmigen metallischen Gateelektrode, mit einem breiteren Gatekopf und einem schmaleren Gatefuß, welcher in einer Doppelgrabenstruktur angeordnet ist, wobei
- eine Halbleiterschichtenfolge für einen HEMT-Transistor abgeschieden wird und mit einer Kanalschicht (2), über dieser einer niedrig dotierten Abschirmschicht (4) und über dieser einer hoch dotierten Kontaktschicht (5)
- über der Kontaktschicht wenigstens eine erste Hilfsschicht (9) abgeschieden wird,
- in der ersten Hilfsschicht (9) eine die Struktur des Gatefußes bestimmende erste Öffnung (9a) erzeugt wird,
- durch Unterätzen der Hilfsschicht (9) bis zu der Abschirmschicht (4) der breite Graben (50) der Doppelgrabenstruktur erzeugt wird,
- dielektrisches Material (90b) für eine weitere Hilfsschicht durch die erste Öffnung in dem breiten Graben auf der Abschirmschicht abgeschieden wird,
- durch anisotrope Ätzung mit der ersten Öffnung als Maske eine zweite Öffnung (900b) in der weiteren Hilfsschicht bis zu der Abschirmschicht erzeugt wird,
- durch Untersätzen der weiteren Hilfsschicht beidseitig der zweiten Öffnung (900b) der schmale Graben (15) erzeugt wird,
- das Abscheiden von Gatemetall (13c) für den Gatefuß durch die zweite Öffnung (900b) in den schmalen Graben (15) erfolgt.

2. Verfahren nach Anspruch 1, **dadurch gekennzeichnet, dass** als Material für die weitere Hilfsschicht Siliziumnitrid abgeschieden wird.

3. Verfahren nach Anspruch 1 oder 2, **dadurch gekennzeichnet, dass** das Material für die weitere Hilfsschicht nach einem PECVD-Verfahren abgeschieden wird.

4. Verfahren nach einem der Ansprüche 1 bis 3, **dadurch gekennzeichnet, dass** der breite Graben nach dem Abscheiden der weiteren Hilfsschicht mit einem polymerisierbaren Füllstoff ausgefüllt und dieser in dem breiten Graben polymerisiert wird, und dass die zweite Öffnung auch in dem Polymer erzeugt wird.

5. Verfahren nach Anspruch 4, **dadurch gekennzeichnet, dass** vor dem Abscheiden des Gatemetalls die Hilfsschicht (9) über dem Polymer entfernt und Gatemetall für den Gatekopf auf dem Polymer abgeschieden wird.

6. Verfahren nach einem der Ansprüche 1 bis 5, **dadurch gekennzeichnet, dass** zwischen der Kontaktschicht (5) und der ersten Hilfsschicht eine Zwischenschicht (8) abgeschieden wird und dass die Ätzung des breiten Grabens in zwei Schritten erfolgt, wobei in einem ersten Schritt in der Zwischenschicht (8) unter der ersten Hilfsschicht (9) eine gegenüber der ersten Öffnung breitere Öffnung (8b) erzeugt und in einem zweiten Schritt als Maske für die Ätzung des breiten Grabens (50) in der Kontaktschicht (5) benutzt wird.

7. Verfahren nach einem der Ansprüche 1 bis 6, **dadurch gekennzeichnet, dass** vor dem Unterätzen der weiteren Hilfsschicht zur Erzeugung des schmalen Grabens wenigstens eine Lackschicht abgeschieden und in dieser eine Öffnung als Maske für den Gatekopf erzeugt wird.

8. Verfahren nach einem der Ansprüche 1 bis 7, **dadurch gekennzeichnet, dass** nach dem Abscheiden des Gatemetalls die über den Halbleiterschichten verbliebenen Schichten entfernt und eine Passivierungsschicht (20) in einer solchen Dicke abgeschieden wird, dass unterhalb überhängender Gatekopfbereiche geschlossene Hohlräume (21) entstehen.

## Claims

1. Method for producing a microelectronic component comprising a T-shaped metallic gate electrode, having a wider gate head and a narrower gate foot, which is arranged in a double trench structure, wherein
- a semiconductor layer sequence for an HEMT transistor is deposited, comprising a channel layer (2), thereabove a lightly doped screening layer (4) and thereabove a highly doped contact layer (5),
- at least one first auxiliary layer (9) is deposited above the contact layer,
- a first opening (9a), which determines the structure of the gate foot, is produced in the first auxiliary layer (9),
- the wide trench (50) of the double trench structure is produced by means of undercutting of the auxiliary layer (9) as far as the screening layer (4),
- dielectric material (90b) for a further auxiliary layer is deposited through the first opening in the wide trench on the screening layer,
- by means of anisotropic etching with the first opening as mask, a second opening (900b) is produced in the further auxiliary layer as far as the screening layer,
- the narrow trench (15) is produced by means of undercutting of the further auxiliary layer on both sides of the second opening (900b),
- gate metal (13c) for the gate foot is deposited through the second opening (900b) into the narrow trench (15).

2. Method according to Claim 1, **characterized in that** silicon nitride is deposited as material for the further auxiliary layer.

3. Method according to Claim 1 or 2, **characterized in that** the material for the further auxiliary layer is deposited according to a PECVD method.

4. Method according to any of Claims 1 to 3, **characterized in that** the wide trench, after the deposition of the further auxiliary layer, is filled with a polymerisable filler and the latter is polymerized in the wide trench, and **in that** the second opening is also produced in the polymer.

5. Method according to Claim 4, **characterized in that**, before the deposition of the gate metal, the auxiliary layer (9) is removed above the polymer and gate metal for the gate head is deposited on the polymer.

6. Method according to any of Claims 1 to 5, **characterized in that** an intermediate layer (8) is deposited between the contact layer (5) and the first auxiliary layer, and **in that** the wide trench is etched in two steps, wherein an opening (8b) wider than the first opening is produced in the intermediate layer (8) below the first auxiliary layer (9) in a first step and is used as mask for the etching of the wide trench (50) in the contact layer (5) in a second step.

7. Method according to any of Claims 1 to 6, **characterized in that**, before the undercutting of the further auxiliary layer for producing the narrow trench, at least one resist layer is deposited and an opening as mask for the gate head is produced in said at least one resist layer.

8. Method according to any of Claims 1 to 7, **characterized in that**, after the deposition of the gate metal, the layers that have remained above the semiconductor layers are removed and a passivation layer (20) is deposited with a thickness such that closed cavities (21) arise below overhanging gate head regions.

## Revendications

1. Procédé de fabrication d'un composant microélectronique à électrode métallique de grille, en forme de T présentant une large tête de grille et un pied de grille plus étroit disposé dans une structure à double sillon, dans lequel
une succession de couches semi-conductrices pour transistor HEMT est déposée et présente une couche de canal (2) sur laquelle sont déposées les unes au-dessus des autres une couche de blindage (4) faiblement dopée, une couche de contact (5) fortement dopée et au moins une première couche auxiliaire (9),
une première ouverture (9a) qui définit la structure du pied de grille est formée dans la première couche auxiliaire (9),
le large sillon (50) de la structure à double sillon est formé en gravant sous la couche auxiliaire (9) jusqu'à la couche de blindage (4),
un matériau diélectrique (90b) pour une autre couche auxiliaire est déposé à travers la première ouverture sur la couche de blindage dans le large sillon,
une deuxième ouverture (900b) est formée dans l'autre couche auxiliaire jusqu'à la couche de blindage, par gravure anisotrope en recourant à la première ouverture comme masque,
le sillon étroit (15) est formé des deux côtés de la deuxième ouverture (900b) en gravant des deux côtés en dessous de l'autre couche auxiliaire et
le dépôt du métal de grille (13c) prévu pour le pied de la grille dans le sillon étroit (15) s'effectue à travers la deuxième ouverture (900b).

2. Procédé selon la revendication 1, **caractérisé en ce que** le matériau déposé pour l'autre couche auxiliaire est le nitrure de silicium.

3. Procédé selon la revendication 1 ou 2, **caractérisé en ce que** le matériau de l'autre couche auxiliaire est déposé par un procédé de PECVD.

4. Procédé selon l'une des revendications 1 à 3, **caractérisé en ce que** le large sillon est rempli d'une charge polymérisable après le dépôt de l'autre couche auxiliaire, **en ce que** cette charge est polymérisée dans le large sillon et **en ce que** la deuxième ouverture est également formée dans le polymère.

5. Procédé selon la revendication 4, **caractérisé en ce que** la couche auxiliaire (9) est enlevée au-dessus du polymère avant le dépôt du métal de grille et **en ce que** le métal de grille prévu pour la tête de grille est déposé sur le polymère.

6. Procédé selon l'une des revendications 1 à 5, **caractérisé en ce qu'**une couche intermédiaire (8) est déposée entre la couche de contact (5) et la première couche auxiliaire et **en ce que** la gravure du large sillon s'effectue en deux étapes, une ouverture (8b) plus large que la première ouverture étant formée dans une première étape dans la couche intermédiaire (8) en dessous de la première couche auxiliaire (9) et étant utilisée dans la deuxième étape pour la gravure du large sillon (50) dans la couche de contact (5).

7. Procédé selon l'une des revendications 1 à 6, **caractérisé en ce qu'**avant de graver en dessous de l'autre couche auxiliaire pour former le sillon étroit, on dépose au moins une couche de vernis et on y forme une ouverture servant de masque pour la tête de grille.

8. Procédé selon l'une des revendications 1 à 7, **caractérisé en ce qu'**après le dépôt du métal de grille, on enlève les couches qui restent au-dessus des couches semi-conductrices et on dépose une couche de passivation (20) à une épaisseur telle que des cavités fermées (21) sont formées en dessous des parties suspendues de la tête de grille.
